# FASCICULE DE BREVET EUROPEEN

(11) **EP 3 167 514 B1**
(45) Date de publication et mention de la délivrance du brevet: **28.08.2019**
(21) Numéro de dépôt: 15734701.4
(22) Date de dépôt: 09.07.2015
(51) Int. Cl.: G01R 31/02, G01R 31/28, H04M 1/02, H04M 1/24, H01R 13/66, H01R 13/703, H01R 24/64

(54) **PROCEDE DE LOCALISATION D'UNE PANNE IMPACTANT UN APPAREIL ÉLECTRIQUE QUI COMPORTE UNE INTERFACE DE COMMUNICATION ET UN CONNECTEUR ELECTRIQUE FEMELLE**
VERFAHREN ZUM ORTEN EINES FEHLERS
METHOD FOR LOCATING A FAULT

(30) Priorité: 10.07.2014 FR 1456688
(43) Date de publication de la demande: 17.05.2017
(73) Titulaire: Sagemcom Broadband SAS, 92500 Rueil-Malmaison (FR)
(72) Inventeur: DANGY-CAYE, Nicolas, F-92500 Rueil Malmaison (FR)
(74) Mandataire: Lavaud, Thomas
(86) Numéro de dépôt international: PCT/EP2015/065735
(87) Numéro de publication internationale: WO 2016/005513

(56) Documents cités:
- EP-A1- 0 654 865
- WO-A1-97/45899
- DE-U1-202010 008 678
- FR-A1- 2 952 760
- US-A- 5 123 854
- US-A1- 2008 267 359

## Description

L'invention concerne le domaine des connecteurs utilisés pour transmettre des signaux électriques, et notamment pour connecter à internet des appareils électriques. L'invention concerne plus particulièrement la détection et la localisation de pannes impactant ce type de connexion.

### ARRIERE PLAN DE L'INVENTION

La testabilité d'un appareil électrique (embarqué, domestique, etc.), c'est-à-dire la capacité de cet appareil électrique à détecter et à localiser une panne perturbant son fonctionnement, est un enjeu majeur de la conception dudit appareil électrique. Une bonne testabilité, se traduisant par l'obtention de taux de détection et de localisation élevés, est avantageuse au moment de la fabrication de l'appareil électrique, car ces taux élevés permettent de garantir que l'appareil électrique livré à l'utilisateur sera fonctionnel. Une bonne testabilité permet aussi, lorsque l'appareil électrique est en service chez l'utilisateur, de diagnostiquer efficacement une panne pour orienter rapidement l'utilisateur vers une solution appropriée permettant de corriger la panne.

Dans le cas d'un appareil électrique de type modem, passerelle résidentielle, décodeur pour la télévision, etc., muni par exemple d'une interface de communication de type ADSL (pour « Asymmetric Digital Subscriber Line »), il convient, en cas de problème impactant l'accès à internet de l'appareil électrique, de déterminer si le problème provient de l'interface de communication ADSL de l'appareil électrique ou bien d'un élément externe à l'appareil (câble électrique Ethernet, filtre ADSL, prise téléphonique, ligne téléphonique, etc.). Une méthode utilisée aujourd'hui pour tester l'interface de communication consiste à débrancher le câble électrique Ethernet, à connecter à l'appareil électrique un accessoire de test livré avec l'appareil électrique et comprenant une résistance de 100 ohms simulant l'impédance de la ligne téléphonique et du câble électrique, et à lancer un programme de test destiné à tester l'interface de communication.

Cette méthode présente un certain nombre d'inconvénients. Au moment de la fabrication de l'appareil électrique, elle nécessite une intervention d'un technicien sur la chaîne de production, ce qui présente un impact non négligeable en termes de durée et de coût de fabrication de l'appareil électrique. Lorsque l'appareil électrique est en service chez l'utilisateur, cette méthode nécessite une intervention de l'utilisateur qui est relativement complexe techniquement pour la majorité des utilisateurs. Cette méthode nécessite en outre l'utilisation de l'accessoire de test qui, étant peu utilisé, risque fort d'être égaré par l'utilisateur. En cas de perte de l'accessoire de test, l'utilisateur est donc obligé de ramener l'appareil électrique à une agence ou à un point de vente alors que l'appareil électrique est potentiellement parfaitement fonctionnel.

Le document FR 2 952 760 A1 concerne une prise murale de type DTI (pour « Dispositif de Terminaison Intérieur") comprenant une prise de test de type RJ45. Le but de l'enseignement de ce document est de définir si une panne provient d'une installation ou d'un réseau, et non si une panne est interne ou externe à un appareil électrique.

### OBJET DE L'INVENTION

L'invention a pour objet d'améliorer la localisation d'une panne impactant un appareil électrique de type modem, passerelle résidentielle, décodeur pour la télévision, etc.

### RESUME DE L'INVENTION

En vue de la réalisation de ce but, on propose un procédé de localisation conforme à la revendication 1.

Le procédé de localisation permet, de manière simple et rapide, de localiser une panne qui impacte l'appareil électrique, c'est-à-dire de déterminer si la panne provient de l'interface de communication de l'appareil ou bien d'un élément externe.

Le procédé de localisation de panne ne nécessite pas l'utilisation d'un accessoire de test séparé.

Pour mettre en oeuvre le procédé de localisation, il suffit de déconnecter le connecteur électrique mâle du connecteur électrique femelle, c'est-à-dire de débrancher de l'appareil électrique le câble électrique dont le connecteur électrique mâle est relié au connecteur électrique femelle, ce qui amène l'élément conducteur du connecteur électrique femelle dans sa position de repos. L'interface de communication est alors connectée via l'élément conducteur aux moyens de test et peut donc être testée.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 représente un appareil électrique de l'invention, en l'occurrence une passerelle résidentielle ADSL vue de derrière et connectée à un ordinateur et à une ligne téléphonique ;
- la figure 2 est une vue de derrière du connecteur électrique femelle de l'invention alors qu'aucun connecteur électrique mâle complémentaire n'est inséré dans le connecteur électrique femelle ;
- la figure 3 est une vue de côté du connecteur de la figure 2 ;
- la figure 4 est une vue de côté analogue à celle de la figure 3, mais en transparence, sur laquelle on distingue des éléments conducteurs situés dans une cavité du connecteur électrique femelle ;
- la figure 5 est une vue analogue à celle de la figure 2, dans laquelle un connecteur électrique mâle complémentaire est inséré dans le connecteur électrique femelle ;
- la figure 6 est une vue de côté du connecteur électrique femelle de la figure 5 ;
- la figure 7 est une vue analogue à celle de la figure 4, dans laquelle un connecteur électrique mâle complémentaire est inséré dans le connecteur électrique femelle
- la figure 8 est un schéma électrique représentant l'appareil électrique et le connecteur électrique femelle muni de moyens de test et de moyens de détection, alors que le connecteur électrique mâle est inséré dans le connecteur électrique femelle ;
- la figure 9 est une vue analogue à celle de la figure 6, dans laquelle le connecteur électrique mâle n'est pas inséré dans le connecteur électrique femelle ;
- la figure 10 représente des étapes du procédé de test de l'invention.

### DESCRIPTION DETAILLEE DE L'INVENTION

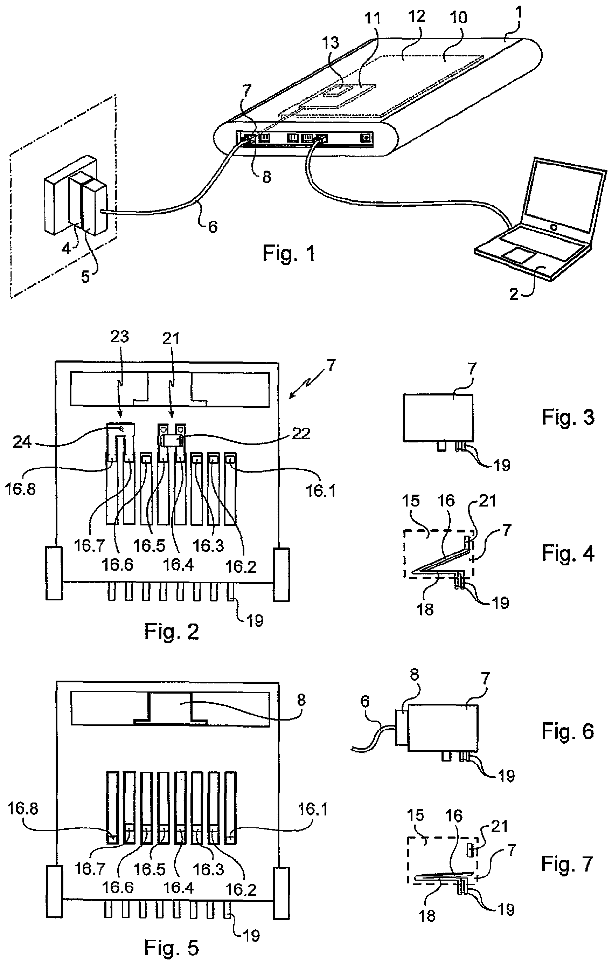

En référence à la figure 1, l'appareil électrique de l'invention est ici une passerelle résidentielle 1 reliée à un ordinateur 2 pour permettre à celui-ci d'échanger des données sur le réseau internet grâce à une connexion de type ADSL.

La passerelle résidentielle 1 est connectée à une ligne téléphonique via une prise téléphonique 4, un filtre ADSL 5 et un câble électrique 6 de type câble Ethernet. La connexion entre la passerelle résidentielle 1 et le câble électrique 6 est réalisée grâce à un connecteur électrique femelle de l'invention 7 situé à l'arrière de la passerelle résidentielle 1 et un connecteur électrique mâle complémentaire 8 dont est muni le câble électrique 6.

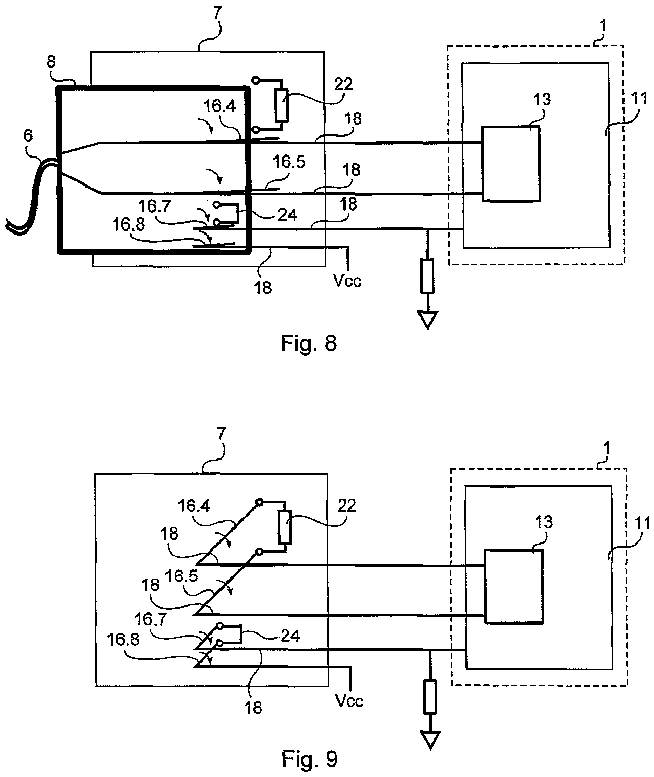

Outre le connecteur électrique femelle 7, la passerelle résidentielle 1 comporte un afficheur LCD 9 (non visible sur la figure 1 car situé à l'avant de la passerelle résidentielle 1, mais visible sur la figure 9), une carte électronique 10 sur laquelle sont montés des composants électroniques, ainsi qu'un certain nombre d'éléments classiquement présents sur une telle passerelle résidentielle et non évoqués ici (connecteur d'alimentation, etc.).

La carte électronique 10 comporte notamment une interface de communication ADSL 11 connectée au connecteur électrique femelle 7 et destinée à gérer l'émission et la réception des données échangées par l'ordinateur 2 via la passerelle résidentielle 1. Cette interface de communication 11 comprend un module de test 13, dont le rôle sera décrit plus loin dans cette description.

Le connecteur électrique femelle 7 et le connecteur électrique mâle 8 sont tous deux des connecteurs de type RJ45.

En référence aux figures 2 à 7, le connecteur électrique femelle 7 comporte une cavité 15 dans laquelle s'étendent huit éléments conducteurs 16 en forme de lamelles élastiques désignés par la référence numérique générale 16 et en particulier par les références numériques 16.1, 16.2, 16.3... 16.8. La cavité 15 est destinée à accueillir le connecteur électrique mâle 8 du câble électrique 6 qui lui-même comporte huit éléments conducteurs complémentaires. Chaque élément conducteur 16 du connecteur électrique femelle 7 établit une connexion électrique avec un élément conducteur complémentaire par contact lorsque le connecteur électrique mâle 8 est inséré dans le connecteur électrique femelle 7.

Chaque élément conducteur 16 est prolongé par une lamelle fixe conductrice 18 qui s'étend dans un fond de la cavité 15 du connecteur électrique femelle 7 et qui est elle-même solidaire d'une patte 19 soudée sur la carte électronique 10 de la passerelle résidentielle 1.

Les huit éléments conducteurs 16 du connecteur électrique femelle 7 sont montés mobiles entre une position active et une position de repos.

La position de repos, visible sur les figures 2 à 4, est une position dans laquelle se trouvent les éléments conducteurs 16 lorsque le connecteur électrique mâle 8 du câble électrique 6 n'est pas inséré dans le connecteur électrique femelle 7. Cette position de repos correspond à une position haute des éléments conducteurs 16 dans la cavité 15.

La position active, visible sur les figures 5 à 7, est une position dans laquelle sont amenés les éléments conducteurs 16 lorsque le connecteur électrique mâle 8 du câble électrique 6 est inséré dans le connecteur électrique femelle 7. Cette position active correspond à une position basse des éléments conducteurs 16 dans la cavité 15, dans laquelle chaque élément conducteur 16 est positionné en contact avec la lamelle fixe 18 associée et sensiblement parallèlement à celle-ci.

Des moyens de test 21 sont positionnés dans le connecteur électrique femelle 7 dans une partie haute de la cavité 15 du connecteur électrique femelle 7. Les moyens de test 21 sont utilisés par le module de test 13 pour déterminer si l'interface de communication 11 est fonctionnelle ou non. Les moyens de test 21 simulent le comportement d'une ligne téléphonique et d'un câble électrique fonctionnels, c'est-à-dire non touchés par un défaut (circuit ouvert, court-circuit, etc.). Ainsi, une panne détectée par le module de test 13 et impactant l'accès à internet de la passerelle résidentielle 1 provient nécessairement de l'interface de communication 11.

Les moyens de test 21 sont disposés de manière à être connectés entre deux premiers éléments conducteurs lorsque les éléments conducteurs 16 sont dans la position de repos. Les deux premiers éléments conducteurs sont ici les éléments conducteurs 16.4 et 16.5 qui sont les éléments conducteurs « actifs » de la connexion ADSL, c'est-à-dire les éléments conducteurs 16 sur lesquels cheminent des signaux électriques correspondant aux données échangées par l'ordinateur 2 via la passerelle résidentielle 1. Les premiers éléments conducteurs 16.4 et 16.5 sont reliés à l'interface de communication 11, et notamment au module de test 13 de l'interface de communication 11, lorsque les premiers éléments conducteurs 16.4 et 16.5 sont dans la position de repos.

Les moyens de test 21 sont ici constitués par une résistance 22 ayant une valeur de résistance de 100 ohms, ce qui correspond à l'impédance de la ligne téléphonique.

Des moyens de détection 23 sont aussi positionnés dans le connecteur électrique femelle 7 dans la partie haute de la cavité 15 du connecteur électrique femelle 7. Les moyens de détection 23 sont destinés à détecter si le connecteur électrique mâle 8 est ou non inséré dans le connecteur électrique femelle 7. Les moyens de détection 23 sont disposés de manière à être connectés entre deux deuxièmes éléments conducteurs lorsque les éléments conducteurs 16 sont dans la position de repos. Les deux deuxièmes éléments conducteurs sont ici les éléments conducteurs 16.7 et 16.8. Les deuxièmes éléments conducteurs 16.7 et 16.8 et les moyens de détection 23 sont reliés à l'interface de communication lorsque les deuxièmes éléments conducteurs 16.7 et 16.8 sont dans la position de repos.

Les moyens de détection 23 sont ici constitués par un shunt 24 qui court-circuite les deux deuxièmes éléments conducteurs 16.7, 16.8 lorsque les deux deuxièmes éléments conducteurs 16.7 et 16.8 se trouvent dans la position de repos.

On décrit maintenant plus en détail le fonctionnement des moyens de test 21 et des moyens de détection 23, en référence aux figures 8 et 9.

Lorsque le connecteur électrique mâle 8 du câble électrique 6 est inséré dans le connecteur électrique femelle 7, comme cela est visible sur la figure 8, les premiers éléments conducteurs 16.4 et 16.5 sont dans la position active et sont donc éloignés physiquement de la résistance 22 et du shunt 24.

Les premiers éléments conducteurs 16.4 et 16.5 sont connectés aux éléments conducteurs complémentaires correspondants du connecteur électrique mâle. Des données peuvent être échangées entre le réseau internet et l'ordinateur 2 via l'interface de communication 11 de la passerelle résidentielle 1.

Les deuxièmes éléments conducteurs 16.7 et 16.8, quant à eux, ne sont pas court-circuités. L'application d'une tension Vcc au niveau du deuxième élément conducteur 16.8 ne génère aucun signal électrique au niveau du deuxième l'élément conducteur 16.7, ce qui est interprété par l'interface de communication 11 comme une indication que le connecteur électrique mâle 8 est inséré dans le connecteur électrique femelle 7.

Lorsque le connecteur électrique mâle 8 du câble électrique 6 n'est pas inséré dans le connecteur électrique femelle 7, comme cela est visible sur la figure 9, les éléments conducteurs 16 sont dans la position de repos.

Les premiers éléments conducteurs 16.4 et 16.5 sont connectés à la résistance 22. Le module de test 13 peut donc effectuer des tests pour vérifier le fonctionnement de l'interface de communication 11 en utilisant la résistance 22 connectée aux premiers éléments conducteurs 16.4 et 16.5.

Les deuxièmes éléments conducteurs 16.7 et 16.8, quant à eux, sont court-circuités par le shunt 24. La tension au niveau du deuxième élément conducteur 16.7 est donc sensiblement égale à celle au niveau du deuxième élément conducteur 16.8. L'application d'une tension Vcc au niveau du deuxième élément conducteur 16.8 génère donc une tension semblable au niveau du deuxième élément conducteur 16.7, ce qui est interprété par l'interface de communication 11 comme une indication que le connecteur électrique mâle 8 n'est pas inséré dans le connecteur électrique femelle 7.

La passerelle résidentielle 1 est ainsi adaptée à fonctionner selon deux modes : un mode normal et un mode de test.

Le mode normal est un mode dans lequel des données peuvent être échangées entre le réseau internet et l'ordinateur 2 via l'interface de communication 11 de la passerelle résidentielle 1. Ce mode normal nécessite donc que le connecteur électrique mâle 8 du câble électrique 6 soit inséré dans le connecteur femelle 7 de la passerelle résidentielle 1.

Le mode de test est un mode dans lequel les moyens de test 21 sont connectés au module de test 13 de l'interface de communication 11. Ce mode de test nécessite donc que le connecteur électrique mâle 8 du câble électrique 6 ne soit pas inséré dans le connecteur électrique femelle 7 de la passerelle résidentielle 1.

On note ici que les moyens de détection 23 fournissent deux avantages relatifs à l'existence de ces deux modes de fonctionnement de la passerelle résidentielle 1.

Les moyens de détection 23 permettent de placer la passerelle résidentielle 1 dans le bon mode de fonctionnement, selon que la présence du connecteur électrique mâle 8 est détectée ou non. Les moyens de détection 23 permettent de plus de valider le résultat du test réalisé par le module de test 13 et visant à déterminer si l'interface de communication 11 est fonctionnelle ou non. En effet, si le test indique que l'interface de communication 11 n'est pas fonctionnelle, il est nécessaire de savoir avec certitude que la résistance 22 est bien connectée au module de test 13 et donc que le connecteur électrique mâle 8 n'est pas inséré dans le connecteur électrique femelle 7. Ainsi, une panne détectée par le module de test 13 et impactant l'accès à internet de la passerelle résidentielle 1 provient nécessairement de l'interface de communication 11 et n'est pas due à la détection erronée par le module de test 13 d'un court-circuit provenant du fait que le module de test considère à tort que la résistance 22 est connectée aux premiers éléments conducteurs 16.4 et 16.5 .

On décrit maintenant le procédé de test de l'invention, qui permet ici de tester l'interface de communication 11 de la passerelle résidentielle 1.

Ce procédé de test doit être lancé par l'utilisateur qui constate qu'un problème impacte l'accès à internet de la passerelle résidentielle 1. Le procédé de test permet de localiser la panne, c'est-à-dire, en l'occurrence, de savoir si la panne provient de la passerelle résidentielle 1 et notamment de l'interface de communication 11, ou bien d'un élément externe à l'appareil (câble électrique 6, filtre ADSL 5, prise téléphonique 4, ligne téléphonique 3, etc.).

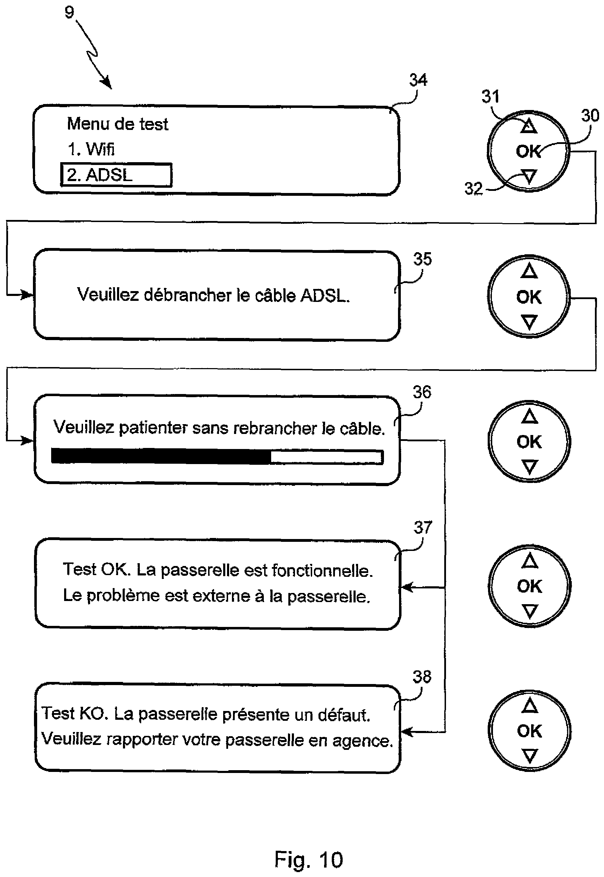

En référence à la figure 10, l'utilisateur interagit avec l'afficheur LCD 9 de la passerelle résidentielle ainsi qu'avec un bouton « ok » 30, une flèche « haut » 31 et une flèche « bas » 32. La flèche « haut » 31 et la flèche « bas » 32 permettent à l'utilisateur de sélectionner des options figurant dans des menus affichés par l'afficheur LCD 9, alors que le bouton « ok » 30 permet de valider la sélection.

Le procédé de test comporte tout d'abord une étape de configuration, au cours de laquelle l'utilisateur choisit de mettre la passerelle résidentielle 1 dans le mode de test.

Le choix du mode de test donne lieu à l'affichage d'un premier menu 34 qui invite l'utilisateur à choisir entre un test de l'interface de communication ADSL 11 ou un test d'une interface de communication WIFI (ce dernier test, qui ne concerne pas l'invention, n'est pas plus évoqué dans cette description). Après avoir choisi de tester l'interface de communication ADSL 11, l'utilisateur est invité par un deuxième menu 35 à débrancher le câble électrique 6 de la passerelle résidentielle 1.

L'interface de communication 11 vérifie alors, en utilisant les moyens de détection 23 du connecteur électrique femelle 7, que le connecteur électrique mâle 8 est bien déconnecté. Si ce n'est pas le cas, l'utilisateur est invité à nouveau à débrancher le câble électrique 6. Après que le câble électrique 6 ait été effectivement débranché, le module de test 13 de l'interface de communication 11 teste l'interface de communication 11 en coopérant avec la résistance 22 des moyens de test 21 du connecteur électrique femelle 7. L'utilisateur est invité par un troisième écran 36 à patienter sans rebrancher le câble 6, le temps que le test de l'interface de communication 11 soit effectué.

Puis, selon le résultat du test, le procédé de test fournit un diagnostic qui consiste à déterminer si l'interface de communication 11 de la passerelle résidentielle 1 est ou non défectueuse. Si l'interface de communication 11 de la passerelle résidentielle 1 n'est pas défectueuse, un quatrième menu 37 l'indique à l'examinateur en précisant que le problème provient d'un élément externe à la passerelle résidentielle 1.

Si l'interface de communication 11 de la passerelle résidentielle 1 est défectueuse, un cinquième menu 38 l'indique à l'utilisateur, en le priant de rapporter la passerelle résidentielle 1 à une agence.

On note qu'il est parfaitement possible de mettre en oeuvre le procédé de test de l'invention sans munir le connecteur électrique femelle 7 des moyens de détection 23. Il est dans ce cas souhaitable, après avoir invité l'utilisateur à débrancher le câble électrique 6 (menu 35), de lui demander de valider ce débranchement en appuyant sur le bouton « ok » 30.

L'invention n'est pas limitée au mode de mise en oeuvre particulier qui vient d'être décrit, mais, bien au contraire, couvre toute variante entrant dans le cadre de l'invention telle que définie par les revendications.

Bien que l'on ait indiqué que les moyens de test sont constitués par une seule résistance, ceux-ci peuvent bien sûr comprendre tout type de charge formée par une ou plusieurs résistances, inductances, capacités, ainsi que d'autres composants passifs ou actifs.

Bien que l'on ait décrit que le connecteur femelle de l'invention comporte huit éléments conducteurs, l'invention s'applique à un connecteur électrique femelle comprenant au moins un élément conducteur. Dans le cas où le connecteur femelle comporte un unique élément conducteur, les moyens de test sont par exemple connectés entre l'élément conducteur et une partie conductrice du connecteur électrique femelle reliée à une masse de l'appareil électrique lorsque l'élément conducteur est dans la position de repos.

Bien que l'on ait utilisé un module de test inclus dans l'interface de communication et destiné à tester le fonctionnement de l'interface de communication, il est bien sûr possible soit d'utiliser un module de test situé à l'extérieur de l'interface de communication, soit d'utiliser des composants de l'interface de communication ne formant pas un module distinct.

L'invention concerne également d'autres types de connecteurs que les connecteurs de type RJ45, par exemples des connecteurs de type RJ11.

## Revendications

1. Procédé de localisation d'une panne impactant un appareil électrique (1), ledit appareil électrique comportant une interface de communication (11) et un connecteur électrique femelle (7) relié à l'interface de communication (11), le connecteur électrique femelle comprenant au moins un élément conducteur (16) monté mobile entre une position active et une position de repos, la position active étant la position dans laquelle l'élément conducteur (16) est amené lorsqu'un connecteur électrique mâle (8) est inséré dans le connecteur électrique femelle (7) et la position de repos étant la position de l'élément conducteur (16) lorsque le connecteur électrique mâle (8) n'est pas inséré dans le connecteur électrique femelle (7), le connecteur électrique femelle (7) comportant des moyens de test (21) connectés à l'élément conducteur (16) lorsque celui-ci se trouve dans la position de repos, les moyens de test (21) simulant le comportement d'une ligne téléphonique et d'un câble électrique fonctionnels ; le procédé de localisation comportant :
- une étape de débranchement, réalisée par un utilisateur de l'appareil électrique (1), consistant à déconnecter le connecteur électrique mâle (8) du connecteur électrique femelle (7) ;
- une étape de test suivant l'étape de débranchement et consistant à tester l'interface de communication (11) en coopérant avec les moyens de test (21) du connecteur électrique femelle (7) ;
- une étape de localisation consistant à localiser la panne dans l'appareil électrique si l'interface de communication est défectueuse ou dans un élément externe à l'appareil électrique si l'interface de communication n'est pas défectueuse.

2. Procédé de localisation selon la revendication 1, dans lequel les moyens de test comportent une résistance connectée entre deux premiers éléments conducteurs (16.4, 16.5) du connecteur électrique femelle lorsque les deux premiers éléments conducteurs (16.4, 16.5) se trouvent dans la position de repos.

3. Procédé de localisation selon l'une des revendications précédentes, dans lequel le connecteur électrique femelle (7) comporte des moyens de détection (23) destinés à détecter si le connecteur électrique mâle (8) est inséré ou non dans le connecteur électrique femelle (7), et dans lequel le procédé de localisation comporte une étape de détection suivant l'étape de débranchement et consistant à vérifier que le connecteur électrique mâle (8) est bien débranché.

4. Procédé de localisation selon la revendication 3, dans lequel l'utilisateur est invité à déconnecter le connecteur électrique mâle (8) si celui-ci n'est pas déconnecté lorsque l'étape de détection est mise en oeuvre.

5. Procédé de localisation selon l'une des revendications 3 ou 4, dans lequel les moyens de détection comportent un shunt qui court-circuite deux deuxièmes éléments conducteurs (16.7, 16.8) du connecteur électrique femelle (7) lorsque les deux deuxièmes éléments conducteurs (16.4, 16.5) se trouvent dans la position de repos

6. Procédé de localisation selon l'une des revendications précédentes, dans lequel l'étape de débranchement est précédée par une étape de configuration consistant à mettre l'appareil électrique (1) dans un mode de test.

7. Procédé de localisation selon l'une des revendications précédentes, dans lequel l'utilisateur interagit avec l'appareil électrique grâce à un afficheur LCD et un bouton de l'appareil électrique.

8. Procédé de localisation selon l'une des revendications précédentes, le procédé de localisation étant mis en oeuvre par un module de test (13) inclus dans l'interface de communication.

9. Appareil électrique de type passerelle résidentielle comprenant une interface de communication (11) et un connecteur électrique femelle (7) relié à l'interface de communication (11), le connecteur électrique femelle comprenant au moins un élément conducteur (16) monté mobile entre une position active et une position de repos, la position active étant la position dans laquelle l'élément conducteur (16) est amené lorsqu'un connecteur électrique mâle (8) est inséré dans le connecteur électrique femelle (7) et la position de repos étant la position de l'élément conducteur (16) lorsque le connecteur électrique mâle (8) n'est pas inséré dans le connecteur électrique femelle (7), le connecteur électrique femelle (7) comportant des moyens de test (21) connectés à l'élément conducteur (16) lorsque celui-ci se trouve dans la position de repos, l'interface de communication comprenant un module de test agencé pour mettre en oeuvre le procédé de localisation selon l'une des revendications précédentes.

## Patentansprüche

1. Ortungsverfahren zur Ortung eines Fehlers, der sich auf ein elektrisches Gerät (1) auswirkt, wobei das genannte elektrische Gerät eine Kommunikationsschnittstelle (1) und eine elektrische Verbinderbuchse (7) umfasst, die mit der Kommunikationsschnittstelle (11) verbunden ist, wobei die elektrische Verbinderbuchse mindestens ein leitendes Element (16) umfasst, das zwischen einer aktiven Position und einer Ruheposition beweglich gelagert ist, wobei die aktive Position die Position ist, in die das leitende Element (16) gebracht wird, wenn ein elektrischer Steckverbinder (8) in die elektrische Verbinderbuchse (7) eingefügt wird, und die Ruheposition die Position des leitendenden Elements (16) ist, wenn der elektrische Steckverbinder (8) nicht in die elektrische Verbinderbuchse (7) eingefügt ist, wobei die elektrische Verbinderbuchse (7) Testmittel (21) umfasst, die mit dem leitenden Element (16) verbunden sind, wenn sich dieses in der Ruheposition befindet, wobei die Testmittel (21) das Verhalten einer Telefonleitung und eines funktionalen elektrischen Kabels simulieren, wobei das Ortungsverfahren umfasst:
- einen Abschaltungsschritt, der von einem Nutzer des elektrischen Geräts (1) ausgeführt wird und darin besteht, den elektrischen Steckverbinder (8) von der elektrischen Verbinderbuchse (7) zu trennen;
- einen Testschritt, der auf den Abschaltungsschritt folgt und darin besteht, die Kommunikationsschnittstelle (11) in Zusammenarbeit mit den Testmitteln (21) der elektrischen Verbinderbuchse (7) zu testen;
- einen Ortungsschritt, der darin besteht, den Fehler in dem elektrischen Gerät zu orten, wenn die Kommunikationsschnittstelle fehlerhaft ist, oder in einem zum elektrischen Gerät externen Element, wenn die Kommunikationsschnittstelle nicht fehlerhaft ist.

2. Ortungsverfahren nach Anspruch 1, bei dem die Testmittel einen Widerstand umfassen, der zwischen zwei ersten leitenden Elementen (16.4, 16.5) der elektrischen Verbinderbuchse geschaltet ist, wenn sich die beiden ersten leitenden Elemente (16.4, 16.5) in der Ruheposition befinden.

3. Ortungsverfahren nach einem der vorhergehenden Ansprüche, bei dem die elektrische Verbinderbuchse (7) Detektionsmittel (23) umfasst, die dazu bestimmt sind, zu erfassen, ob der elektrische Steckverbinder (8) in die elektrische Verbinderbuchse (7) eingeführt ist oder nicht, und bei dem das Ortungsverfahren einen Detektionsschritt umfasst, der auf den Abschaltungsschritt folgt und darin besteht, zu verifizieren, ob der elektrische Steckverbinder (8) richtig ausgeschaltet wurde.

4. Ortungsverfahren nach Anspruch 3, bei dem der Nutzer aufgefordert wird, den elektrischen Steckverbinder (8) zu trennen, falls dieser nicht getrennt ist, wenn der Detektionsschritt ausgeführt wird.

5. Ortungsverfahren nach einem der Ansprüche 3 oder 4, bei dem die Detektionsmittel einen Shunt umfassen, der zwei zweite leitende Elemente (16.7, 16.8) der elektrischen Verbinderbuchse (7) kurzschließt, wenn sich die beiden zweiten leitenden Elemente (16.4, 16.5) in der Ruheposition befinden.

6. Ortungsverfahren nach einem der vorhergehenden Ansprüche, bei dem dem Abschaltungsschritt ein Konfigurationsschritt vorausgeht, der darin besteht, das elektrische Gerät (1) in einen Testmodus zu versetzen.

7. Ortungsverfahren nach einem der vorhergehenden Ansprüche, bei dem der Nutzer mit dem elektrischen Gerät dank einer LCD-Anzeige und einem Knopf des elektrischen Geräts interagiert.

8. Ortungsverfahren nach einem der vorhergehenden Ansprüche, wobei das Ortungsverfahren von einem Testmodul (13) durchgeführt wird, das in der Kommunikationsschnittstelle enthalten ist.

9. Elektrisches Gerät vom Typ Residential Gateway, umfassend eine Kommunikationsschnittstelle (11) und eine elektrische Verbinderbuchse (7), die mit der Kommunikationsschnittstelle (11) verbunden ist, wobei die elektrische Verbinderbuchse mindestens ein leitendes Element (16) umfasst, das zwischen einer aktiven Position und einer Ruheposition beweglich gelagert ist, wobei die aktive Position die Position ist, in die das leitende Element (16) gebracht wird, wenn ein elektrischer Steckverbinder (8) in die elektrische Verbinderbuchse (7) eingefügt wird, und die Ruheposition die Position des leitenden Elements (16) ist, wenn der elektrische Steckverbinder (8) nicht in die elektrische Verbinderbuchse (7) eingefügt ist, wobei die elektrische Verbinderbuchse (7) Testmittel (21) umfasst, die mit dem leitenden Element (16) verbunden sind, wenn sich dieses in der Ruheposition befindet, wobei die Kommunikationsschnittstelle ein Testmodul umfasst, das ausgebildet ist, um das Ortungsverfahren nach einem der vorhergehenden Ansprüche durchzuführen.

## Claims

1. A locating method for locating a failure impacting an electrical appliance (1), said electrical appliance having a communications interface (11) and a female electric connector (7) connected to the communications interface (11), the female electric connector having at least one conductor element (16) mounted to move between an active position and a rest position, the active position being the position into which the conductor element (16) is taken when a male electric connector (8) is inserted in the female electric connector (7), and the rest position being the position of the conductor element (16) when the male electric connector (8) is not inserted in the female electric connector (7), the female electric connector (7) including test means (21) connected to the conductor element (16) when it is in the rest position, the test means (21) simulating the behavior of a telephone line and an electric cable that are operational; the locating method comprising:
• a disconnection step performed by a user of the electrical appliance (1) and consisting in disconnecting the male electric connector (8) from the female electric connector (7);
• a test step following the disconnection step and consisting in testing the communications interface (11) in co-operation with the test means (21) of the female electric connector (7);
• a locating step consisting in locating the failure in the electrical appliance if the communications interface is faulty or in an element external to the electrical appliance if the communications interface is not faulty.

2. A locating method according to claim 1, wherein the test means include a resistor connected between two first conductor elements (16.4, 16.5) of the female electric connector when the two first conductor elements (16.4, 16.5) are in the rest position.

3. A locating method according to either preceding claim, wherein the female electric connector (7) includes detector means (23) for detecting whether the male electric connector (8) is or is not inserted in the female electric connector (7), and wherein the locating method includes a detection step following the disconnection step and consisting in verifying that the male electric connector (8) is indeed disconnected.

4. A locating method according to claim 3, wherein the user is invited to disconnect the male electric connector (8) if it is not disconnected when the detection step is performed.

5. A locating method according to claim 3 or claim 4, wherein the detector means comprise a shunt that short-circuits two second conductor elements (16.7, 16.8) of the female electric connector (7) when the two second conductor elements (16.4, 16.5) are in the rest position.

6. A locating method according to any preceding claim, wherein the disconnection step is preceded by a configuration step consisting in putting the electrical appliance (1) in a test mode.

7. A locating method according to any preceding claim, wherein the user interacts with the electrical appliance via an LCD display and a button of the electrical appliance.

8. A locating method according to any preceding claim, wherein the locating method is performed by a test module (13) included in the communications interface.

9. An electrical appliance of the residential gateway type including a communications interface (11) and a female electric connector (7) connected to the communications interface (11), the female electric connector having at least one conductor element (16) mounted to move between an active position and a rest position, the active position being the position into which the conductor element (16) is taken when a male electric connector (8) is inserted in the female electric connector (7), and the rest position being the position of the conductor element (16) when the male electric connector (8) is not inserted in the female electric connector (7), the female electric connector (7) including test means (21) connected to the conductor element (16) when it is in the rest position, the communications interface including a test module arranged to perform the locating method according to any preceding claim.
